# EUROPEAN PATENT SPECIFICATION

(11) **EP 0 311 087 B1**
(45) Date of publication and mention of the grant of the patent: **10.02.1993**
(21) Application number: 88116618.5
(22) Date of filing: 07.10.1988
(51) Int. Cl.: H01L 23/544, H01L 21/00

(54) **Identifying semiconductor wafers**
Identifizierung von Halbleiterplättchen
Identification de plaquettes semi-conductrices

(30) Priority: 09.10.1987 JP 255242/87
(43) Date of publication of application: 12.04.1989
(73) Proprietor: FUJITSU LIMITED, Kawasaki-shi, Kanagawa 211 (JP)
(72) Inventor: Kiriseko, Tadashi c/o Fujitsu Limited, Kawasaki-shi Kanagawa 211 (JP)
(74) Representative: Sunderland, James Harry

(56) References cited:
- EP-A- 0 249 762
- FR-A- 2 179 632
- US-A- 4 010 355
- US-A- 4 292 576

## Description

The present invention relates to the identification of semiconductor wafers.

In mass production of semiconductor devices of a specific kind, a method of lot production control is generally applied, wherein a plurality of wafers are subjected to a collective production control using the same lot number. In this case, there is no need to identify each wafer, and a lot number is given to a carrier or container carrying the plurality of wafers.

However, in production of a small quantity of integrated circuits such as ASICs (Application Specific Integrated Circuits) or gate array integrated circuits, it is required that each wafer be identified throughout all, or many of, the processes involved in fabrication of the integrated circuits.

In a previously used method for identifying each wafer, a code pattern, comprising numeral or character marks, or preferably a bar code pattern, is formed by etching a silicon surface of the wafer utilizing photolithography technology or by scribing the surface with a laser beam.

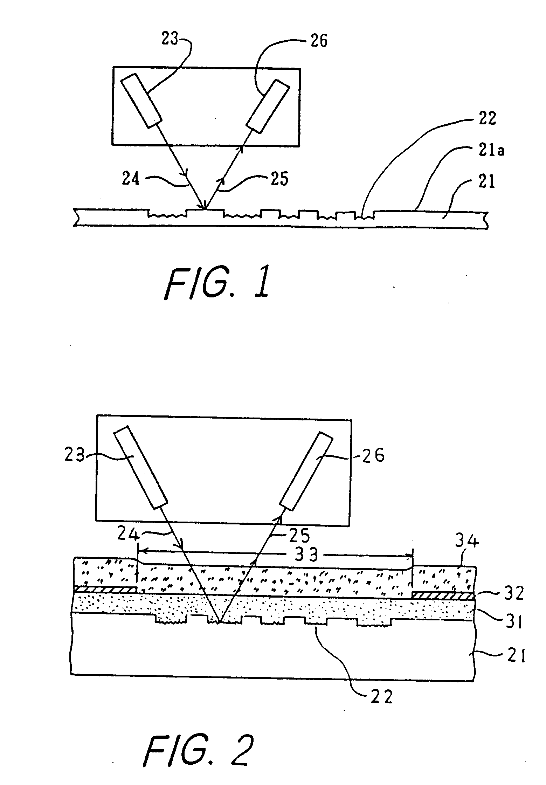

The bar code pattern, for instance, is usually formed in a peripheral region near an orientation flat edge of a silicon wafer. Fig. 1 is a schematic cross-sectional view taken along a line crossing such a bar code pattern. The bar code pattern 22 is formed on a surface 21a of a silicon wafer 21 by scribing and roughening the silicon surface with a laser beam. A light source 23 is provided at the front side of the wafer and irradiates a light beam 24 onto the bar code pattern. A reflected light beam 25 is received by a photo detector 26. By sweeping the light beam 24 over the bar code pattern 22, the bar code pattern can be decoded and the wafer identified.

The principle of the above-described method is very simple. Reflection from an original surface 21a of the wafer, which is not scribed by the laser beam, is regular and stronger in a direction towards the photo detector 26, which is aligned in a direction chosen in accordance with the laws of optics, but reflection from the bar code pattern 22 is irregular and weak. When the output signal from the photo detector is subjected to a slice circuit, the circuit can output selectively a pulse signal corresponding to the bar code pattern.

The above method is subject to some problems. The surface area where the code pattern is formed is subjected to wafer fabrication processes a plurality of times just as parts of the wafer area where active elements are formed are subject to fabrication processes. The processes include, for example, deposition of insulating or metal layers, chemical or physical etching processes, heating processes, etc. When the difference in strengths between reflected light from the code pattern and that from the original wafer surface becomes smaller due to the presence of deposited layers, it is difficult to discriminate a signal corresponding to the code pattern.

In an extreme case, such as when a metal layer is deposited on an area of the code pattern, identification becomes impossible without removing the metal layer from this area. Fig. 2 illustrates schematically a cross-section of a wafer, on which an insulating layer 31, a metal layer 32 of aluminum alloy, and protective layer 34 are deposited on the area of a code pattern 22. A window 33 is formed in the metal layer 32 in order to allow incident light beam 24 to arrive at the surface of the wafer 21. Even with such a window, intermediate layers such as 31 and 34 disturb transmission of incident and reflected light beams, resulting in a decrease of contrast between the reflected light from the code pattern and that from the wafer surface.

In order to overcome this problem, a method for identifying a wafer has been proposed wherein a bar code pattern is formed in a metal layer, infrared rays are irradiated onto one side of the wafer, and transmitted rays passing through the wafer and the bar code pattern are received on the other side thereof. The method is the subject of European Patent No. 0 249 762.

Another method proposed for identifying a wafer, avoiding the above problem, involves forming a bar code pattern on a bottom surface of the wafer with both a light source and a detector for receiving reflected light placed at the bottom side of the wafer, thus avoiding the effects of deposited layers on the front surface of the wafer. U.S. Patent No. 4,010,355 by K. E. Roehrman et al. discloses utilization of this method.

However, the method of forming the code pattern on the bottom surface of the wafer also suffers problems. One problem is that when the code pattern is formed by scribing the wafer surface by a laser beam and evaporating silicon material, silicon material is liable to heap up on a peripheral portion of the pattern which degrades the flatness of the bottom or back surface of the wafer, resulting in a defocusing problem in photolithography processes applied to the front surface. In some cases, the bottom or back surface of the wafer is subjected to a grinding process before it is separated into chips for packaging, and in this case, the code pattern is erased.

According to the present invention there is provided a method of identifying a semiconductor wafer, utilizing a code pattern formed on or above a major surface defining the front surface of the wafer and a light source and a detector disposed at the opposite major surface defining the back surface of the wafer, the method comprising the steps of:-
(a) forming the code pattern to comprise first and second regions of different light-reflecting properties;
(b) irradiating said back surface of the semiconductor wafer with infrared rays from the light source, the infrared rays penetrating through the semiconductor wafer to the code pattern and reflecting therefrom;
(c) receiving said infrared rays reflected from the code pattern at the detector; and
(d) identifying the semiconductor wafer by decoding the received light signal.

An embodiment of the present invention can provide a method of identifying a semiconductor wafer, wherein a code pattern is formed on a front surface of the wafer and which method allows correct wafer identification even when a plurality of layers is deposited thereon during wafer fabrication processes.

An embodiment of the present invention can provide a method of identifying a semiconductor wafer wherein a code pattern is formed on a front side of the wafer, infrared rays are irradiated onto a back side of the wafer and reflected infrared rays received at the back side of the wafer, unaffected by layers deposited on the code pattern.

An embodiment of the present invention can provide a method of identifying a semiconductor wafer, wherein surface flatness of the back side of the wafer is maintained, there being no laser scribing of the back surface of the wafer, a code pattern being formed on a front side thereof.

In accordance with an embodiment of the present invention, a code pattern is formed on a front surface of the wafer, infrared rays are irradiated onto a back side thereof, infrared rays penetrating through the wafer and being reflected from the back side of the code pattern are received and detected, and the wafer identified therefrom.

Preferably, the code pattern is formed near an orientation flat edge of the wafer and comprises first and second regions, light intensities of reflections from the first and second regions, as received by the detector, being different. In practical applications, the code pattern is for example formed by directly scribing a wafer surface by a laser beam at an initial stage of wafer processing or is formed in a metallization layer by laser scribing or by a photolithography method during subsequent wafer processes.

A bar code pattern is preferable to other code patterns using numerals and/or characters because of the simplicity of automatic identification with bar codes.

In accordance with an embodiment of the invention, a wafer can be identified in the course of fabrication processes by irradiating infrared rays onto a back side of the wafer and receiving reflected rays from a code pattern formed on a front surface thereof. This can allow identification of a semiconductor wafer in circumstances in which identification is difficult using a conventional method, in which a code pattern is formed on a front surface of a wafer and light is irradiated on a front side thereof and the reflected light from the code pattern is received at the front side. With such a conventional method, when a plurality of layers are deposited on the code pattern, it becomes difficult to discriminate a code pattern identification signal from the reflected light.

Reference is made, by way of example, to the accompanying drawings, in which:-
Fig. 1 is a schematic side cross-sectional view illustrating a previously proposed method of identifying a semiconductor wafer,
Fig. 2 shows a cross-section of a semiconductor wafer for explaining a problem which arises when the method of Fig. 1 is applied to actual wafer processes,
Fig. 3 is a top view of a semiconductor wafer illustrating a preferred position for a code pattern on the wafer, in embodiments of the present invention,
Fig. 4 is a schematic cross-sectional view of a semiconductor wafer for assistance in explaining an embodiment of the present invention,
Fig. 5 is a schematic cross-sectional view of a semiconductor wafer for assistance in explaining another embodiment of the present invention,
Fig. 6 shows a cross-section of a semiconductor wafer, wherein a MOS FET is formed on the semiconductor wafer and a plurality of layers is deposited on the code pattern, for explaining operation of the embodiment of the present invention, illustrated by Fig. 5, in more realistic circumstances,
Fig. 7 is a flow chart of wafer processing, mainly showing steps subsequent to formation of a code pattern, effected in relation to the semiconductor wafer of Fig. 6,
Fig. 8 is another flow chart of wafer processing, relating to a case in which an embodiment of the present invention as explained with reference to Fig. 4 is applied, and a code pattern is formed in a metal layer, and
Figs. 9 to 12 are respective cross-sectional views corresponding to various steps in wafer processing as indicated by the flow chart of Fig. 8, wherein a code pattern region is subjected to a plurality of deposition processes related to formation of a bipolar transistor in another region of the wafer.

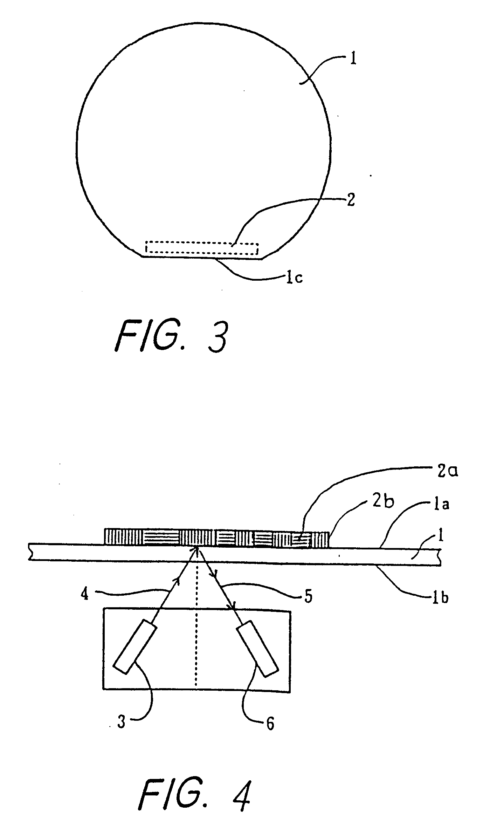

Fig. 3 is a top view of a wafer illustrating where a code pattern is preferably formed. A circular wafer 1 has a flat edge 1c for orientation of the wafer. The code pattern 2 is formed in a region on the wafer surface near the orientation flat edge 1c substantially parallel thereto.

Fig. 4 assists in explanation of one embodiment of the present invention. In Fig. 4, a code pattern is formed by two different materials 2a and 2b deposited on a wafer 1, the two materials having different reflectances. For instance, one material may be aluminum alloy and the other an insulating material such as silicon dioxide. A light source 3 is provided at the back side 1b of the wafer 1 and irradiates an incident beam 4 of infrared rays onto the back or bottom surface 1b of the wafer 1. It is known that infrared rays, the wavelength thereof being longer than 1.3 µm, easily penetrate and transmit through for instance a silicon substrate, therefore, the infrared rays penetrate into the silicon wafer 1 and are reflected from an interface 1a between the wafer and the deposited layers 2a or 2b. Where the deposited material at the interface is aluminum alloy, a larger reflection of infrared rays is expected than that from regions where the other material is at the interface. Reflected rays 5 are received by a detector 6 and generate a signal having a difference in the signal level depending on the material of the deposited layer.

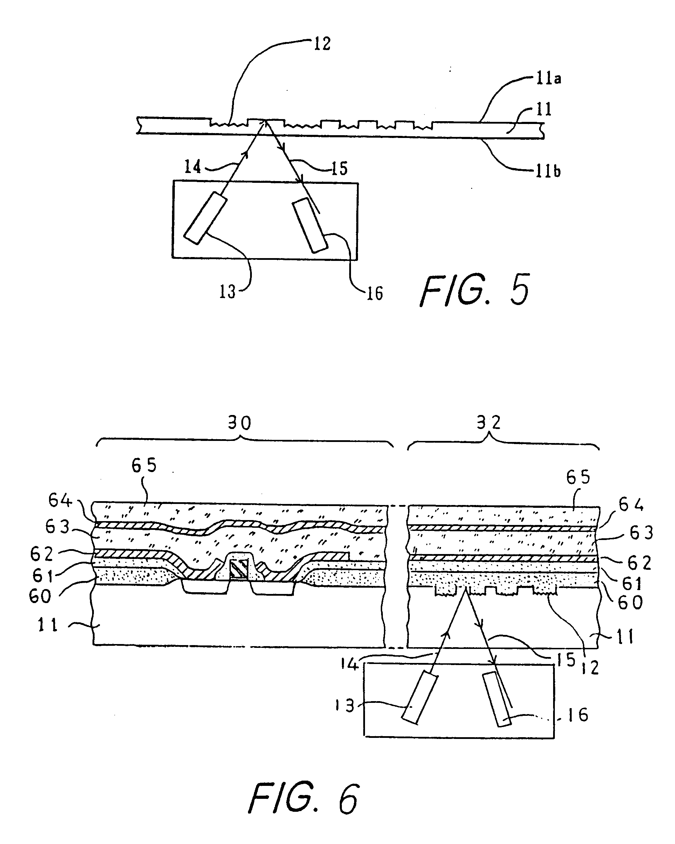

Fig. 5 is a cross-sectional view which assists in explanation of another embodiment of the present invention wherein a code pattern 12 is formed by scribing a silicon surface 11a of a wafer 11 by a laser beam. When the silicon surface 11a is scribed by the laser beam, the silicon material evaporates and the scribed area 12 is made rough, which forms the code pattern 12 in Fig. 5. When an incident beam 14 from a light source 13 including infrared rays is irradiated onto a back surface 11b of the wafer 11, reflection from the silicon surface not subjected to laser scribing is stronger than that from a scribed area of the code pattern 12. The direction of a reflected beam 15 in the former case, ideally, conforms to the law of optical reflection. However, the reflection in the latter case (from a scribed area) is irregular. Therefore, if the axis of a detector 16 for receiving reflected infrared rays is tilted away from the axis corresponding to reception of rays regularly reflected, the detector 16 substantially generates a signal corresponding to the irregular reflections from the code pattern area 12.

As the light source 3 or 13 of Figs. 4 or 5, a tungsten lamp which includes both visible and infrared rays or a helium-neon gas laser which abundantly includes 3.39 µm infrared rays can be used. Many other kinds of semiconductor LEDs and lasers for example can be used. As the detector 6 or 16, a CCD sensor comprising a plurality of sensing elements can be utilized. The CCD sensor can be incorporated within an optical system to form the detector 6 or 16, and an output signal from the detector can then be subjected to a slice circuit and is converted to a signal corresponding to the code pattern (details are omitted in the Figures).

In actual production of integrated circuits, the method explained in outline with reference to Fig. 5 is suitable for a case where each wafer is to be identified from an initial stage of wafer processing. However, the method outlined by Fig. 4 is suitable for a case where a plurality of wafers are collectively subjected to the same bulk wafer processes before a first metallization process. In this case, it is not necessary to identify each wafer but it is sufficient to identify each lot of wafers collectively processed until that time (up to the first metallization process). Thereafter, a code pattern is formed in the metal layer for identification of each wafer. The latter case is especially important for manufacturing ASICs or gate array integrated circuits, in which the patterning process of the metal layer is performed after receiving each customer's specification.

Fig. 6 gives a cross-sectional view of a wafer for illustrating application of a method embodying the present invention, as explained in outline with reference to Fig. 5, to actual fabrication of integrated circuits, wherein a plurality of MOS FETS are formed as active elements in an active region on the wafer and two-level metal layers are required for the MOS FETS. In a first region 30 a partial cross-sectional view of an area in which active elements are formed is given, and in a second region 32, a view of an area in which a code pattern is formed, near an orientation flat edge of the wafer, is given. Generally, a bar code pattern is utilized as the code pattern because of its convenience for automatic formation and recognition.

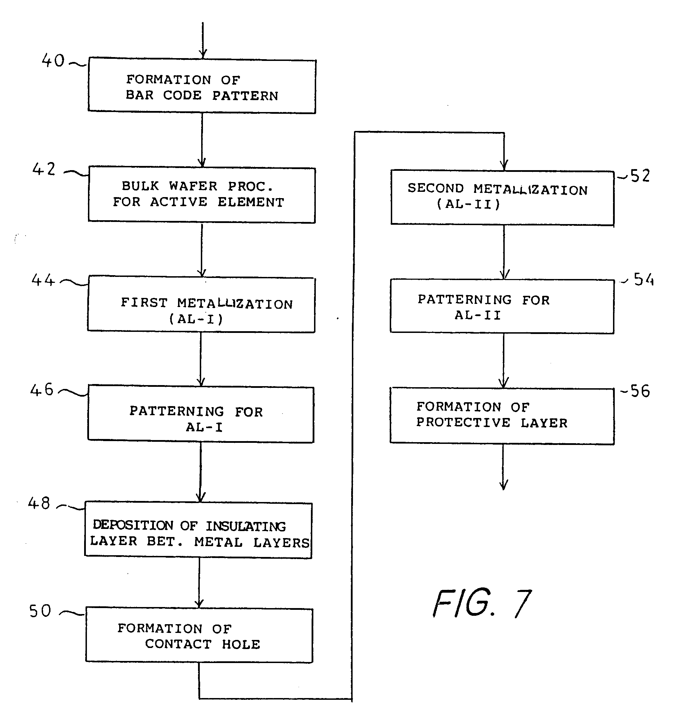

Fig. 7 s a flow chart indicating processes involved in obtaining the structure of Fig. 6. In the flow chart, most steps not related directly to the identification of the wafer are omitted whilst steps related to formation of layers laminated on the second region 32 are indicated. The bar code pattern 12 is formed on a wafer 11 at an initial stage before wafer processes commence, as indicated at step 40. Then, the wafer is subjected to bulk wafer processes (step 42) until a first metallization step 44 is performed. In step 42, most processes or steps for forming an active element, in this case a MOS FET, are performed conventionally. During step 42, a thermally oxidized layer of SiO₂ 60 and a CVD (Chemical Vapor Deposition) layer of SiO₂ 61 are laminated on the bar code pattern 12 in the second region 32, as shown in Fig. 6. Next, the wafer is subjected to a first metallization step (AL-I) 44 and a metal layer 62 of, for example, aluminum alloy is deposited thereon. The metal layer 62 in the first region 30 is patterned in step 46. An insulating layer 63 of, for example, PSG is formed in a step 48, a contact hole is formed in a step 50, and a second metal layer 64 (AL-II) is deposited in a step 52 and patterned in a step 54, and finally, a protective layer 65 is formed on the wafer in a step 56.

Every time the wafer is required to be identified in the course of the above steps, a light source 13 of infrared rays disposed at the back side of the wafer irradiates an incident beam 14 onto the bar code pattern 12 in the second region 32 from the back side of the wafer. Because the bar code pattern is formed by laser scribing, the scribed surface of the silicon wafer exhibits a scabrous or roughened surface, therefore, the incident and penetrating light beam 14 through the wafer is reflected irregularly. On the other hand, reflection from the surface other than at scribed areas is regular and obeys optical laws. Therefore, when an optical axis of a detector 16 is tilted from a direction suitable for receiving regularly reflected light, the detector receives no (or very little) regularly reflected light. However, the detector can receive light reflected from the bar code pattern (the scribed surface areas).

The above method is not affected by the laminated layers formed on the bar code pattern. In the previously proposed method, where a light source and a detector are disposed on the front side of the wafer, the bar code pattern cannot be detected because of the existence of metal layers. A metal layer reflects almost all incident light, except when a window is formed in the metal layer over the bar code pattern. However, when an embodiment of the present invention is applied, the bar code pattern can be identified regardless of the surface conditions of the wafer in the second region 32.

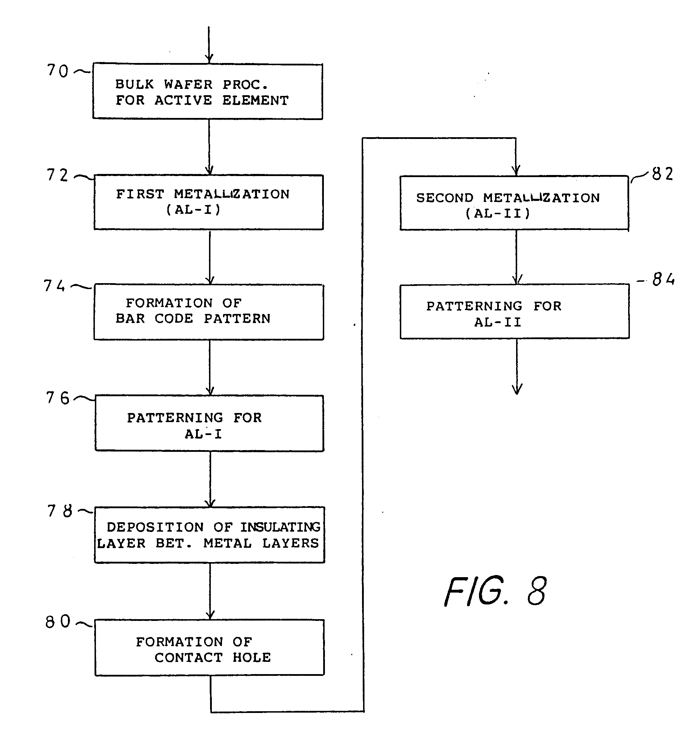

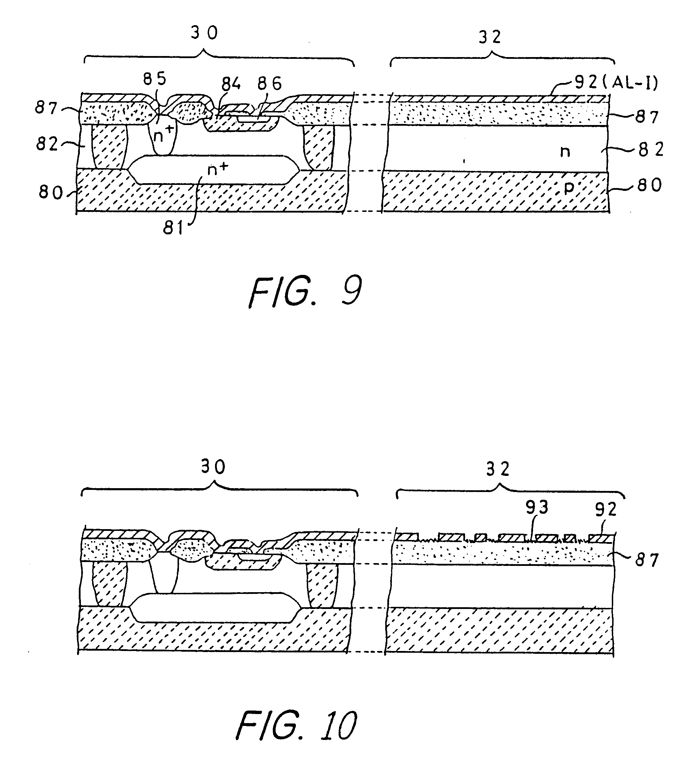

Another embodiment of the present invention, which can be applied in the manufacture of gate array integrated circuits, for instance, will be explained with reference to Figs. 8 to 12. This embodiment is related to the method explained with reference to Fig. 4. Fig. 8 is a flow chart similar to that of Fig. 7. In this case the bar code pattern is formed in a first metal layer (AL-I). Figs. 9 to 12 provide cross-sectional views corresponding to specific steps in Fig. 8. A bipolar transistor is formed in a first region 30, and the bar code pattern is formed in a second region 32. Fig. 9 gives a cross-sectional view of the wafer after completion of a step 70, in which bulk wafer processes for forming a bipolar transistor are carried out, and after completion of a first metallization step 72. A p-type silicon wafer 80 and an n-type epitaxial layer 82 provide a silicon substrate, and an insulating layer 87 of thermally oxidized SiO₂ and a first metal layer 92 (AL-I) are formed thereon in the second region 32. At this time, collector layers 81 and 85, a base region 84, and an emitter region 86 are formed in the first region 30, but the processes involved are conventional, and therefore details are omitted.

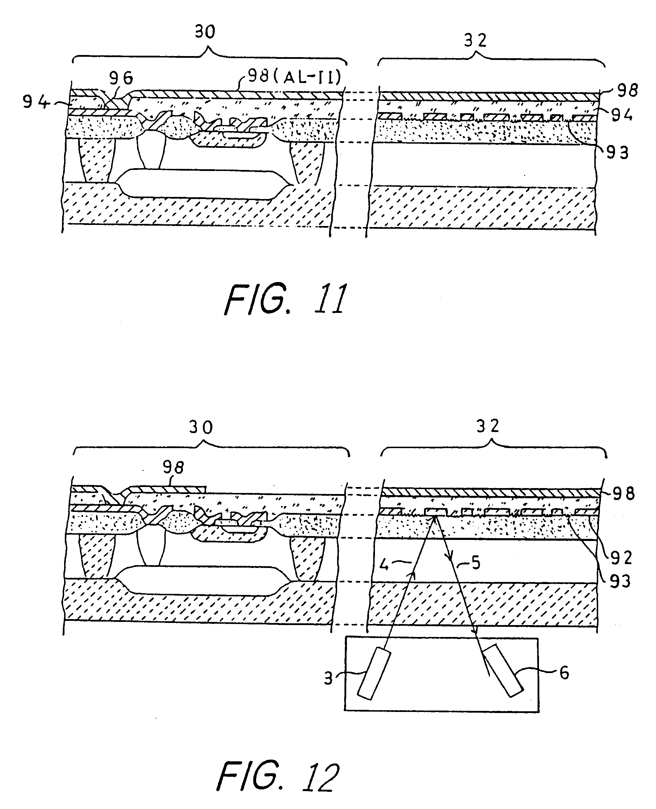

After forming the first metal layer 92, the metal layer in the second region 32 is subjected to a step 74 for forming the bar code pattern by laser scribing, to provide a scribed pattern 93 forming the bar code pattern. When the metal layer 92 is scribed by a laser beam, the metal evaporates and the thus exposed surface 93 of the insulating layer 87 becomes scabrous and roughened as shown in Fig. 10. Thereafter, the metal layer 92 in the first region 30 is patterned in step 76, forming a wiring layer. The entire surface of the wafer is covered by an insulating layer 94 in a step 78, and contact holes 96 are formed in the first region 30 (step 80), and a second metal layer 98 (AL-II) is deposited thereon (step 82) as shown in Fig. 11. Finally, the second metal layer 98 is patterned in a step 84 as shown in Fig 12.

The embodiment of the present invention described above is especially suitable in relation to the manufacture of gate array integrated circuits, whereby identification of each wafer is not necessary before step 72 of Fig. 8. Identification of each wafer is, however, required for example in steps 76 and 84 because different pattern masks are used depending on different customer's requirements.

When the wafer is required to be identified during steps 76 and 84, a light source 3 of infrared rays disposed to the back side of the wafer irradiates an incident beam 4 onto the bar code pattern 93 in the second region 32 from the back side of the wafer. Because the bar code pattern is formed by laser scribing, parts of the metal layer are removed and the surface of the layer below the metal layer is scribed. The scribed surface exhibits a scabrous or roughened form, and therefore incident and penetrating infrared rays are reflected irregularly. On the other hand, the reflection from a back surface of the metal layer 92 is regular and in accordance with optical law. Therefore, when an optical axis of a detector 6 is tilted from a direction suitable for receiving regularly reflected light, the detector receives no or very little regularly reflected light. However, the detector receives irregularly reflected light from the bar code pattern 93.

Of course, the detector may be disposed with its optical axis coincident with a direction suitable for receiving regularly reflected light. In this case, the detected light reflected from the bar code pattern is weaker than that from the metal layer. However, the signal of the bar code pattern can also be discriminated.

Automatic identification of each semiconductor wafer during wafer processing can be achieved by employing an embodiment of the invention, regardless to layers deposited on a code pattern. The code pattern, preferably a bar code pattern, is formed on or above a front surface of the semiconductor wafer, and a light beam including infrared rays is irradiated onto a bottom surface thereof. The infrared rays easily penetrate through the wafer (e.g. of silicon) and reflect from the bar code pattern formed on the front surface of the wafer. The reflect beam of infrared rays is received by a detector disposed to the back side of the wafer, and each wafer can be identified by decoding the received signal. The bar code pattern can be directly formed by scribing the wafer surface by a laser beam or scribing a metal layer deposited thereon.

## Claims

1. A method of identifying a semiconductor wafer, utilizing a code pattern formed on or above a major surface defining the front surface of the wafer and a light source and a detector disposed at the opposite major surface defining the back surface of the wafer, the method comprising the steps of :-
(a) forming the code pattern to comprise first and second regions of different light-reflecting properties;
(b) irradiating said back surface of the semiconductor wafer with infrared rays from the light source, the infrared rays penetrating through the semiconductor wafer to the code pattern and reflecting therefrom;
(c) receiving said infrared rays reflected from the code pattern at the detector; and
(d) identifying the semiconductor wafer by decoding the received light signal.

2. A method as claimed in claim 1, wherein the code pattern is formed by selectively scribing the front surface of the semiconductor wafer by a laser beam to produce roughened areas.

3. A method as claimed in claim 1, wherein the code pattern is formed by depositing a metal layer on or above the front surface of the semiconductor wafer and selectively scribing the metal layer and roughening a surface, of the wafer or another layer, below the metal layer by a laser beam.

4. A method as claimed in claim 1, 2 or 3, wherein an active element is formed on the front surface of the semiconductor wafer.

5. A method as claimed in claim 1, 2, 3 or 4, wherein the code pattern is a bar code pattern.

6. A method as claimed in any preceding claim, wherein the code pattern is formed in a region near an orientation flat edge of the semiconductor wafer.

7. A method as claimed in claim 2, or any of claims 4 to 6 read as appended to claim 2, wherein the code pattern on the front surface of the semiconductor wafer is subjected to the deposition thereon of a plurality of layers including an insulating layer and a metal layer, after step (a).

8. A method as claimed in claim 3, or any of claims 4 to 6 read as appended to claim 3, wherein an active element is formed on the front surface of the semiconductor wafer and the metal layer is deposited as a first metal layer of the active element.

9. A method as claimed in any preceding claim, wherein the optical detection axis of the detector for receiving reflected light in step (c) is tilted away from the direction suitable for receiving regularly reflected light, whereby reflected light from a scribed area having a non-specular reflective property is received by said detector.

10. A method as claimed in any one of claims 1 to 8, wherein the optical detection axis of the detector for receiving reflected light in step (c) is set to coincide with the direction suitable for receiving regularly reflected light.

## Patentansprüche

1. Verfahren zum Identifizieren einer Halbleiterscheibe unter Verwendung eines Codemusters, das auf oder über einer die vordere Fläche der Scheibe definierenden Hauptoberfläche gebildet wird, und einer Lichtquelle sowie eines Detektors, die an der gegenüberliegenden, die hintere Fläche der Scheibe definierenden Hauptoberfläche angeordnet sind, welches Verfahren die Schritte umfaßt:
(a) Bilden des Codemusters, um erste und zweite Zonen mit unterschiedlichen lichtreflektierenden Eigenschaften zu umfassen;
(b) Bestrahlen der genannten hinteren Fläche der Halbleiterscheibe mit Infrarotstrahlen von der Lichtquelle, wobei die Infrarotstrahlen die Halbleiterscheibe zum Codemuster durchdringen und davon reflektiert werden;
(c) Empfangen der genannten vom Codemuster reflektierten Infrarotstrahlen am Detektor; und
(d) Identifizieren der Halbleiterscheibe durch Decodieren des empfangenen Lichtsignals.

2. Verfahren nach Anspruch 1, bei welchem das Codemuster durch selektives Ritzen der vorderen Fläche der Halbleiterscheibe mit einem Laserstrahl gebildet wird, um aufgerauhte Bereiche zu erzeugen.

3. Verfahren nach Anspruch 1, bei welchem das Codemuster durch Abscheiden einer Metallschicht auf oder über der vorderen Fläche der Halbleiterscheibe und selektives Ritzen der Metallschicht sowie Aufrauhen einer Fläche der Scheibe oder einer weiteren Schicht unter der Metallschicht mit einem Laserstrahl gebildet wird.

4. Verfahren nach Anspruch 1, 2 oder 3 bei welchem ein aktives Element auf der vorderen Fläche der Halbleiterscheibe gebildet wird.

5. Verfahren nach Anspruch 1, 2, 3 oder 4, bei welchem das Codemuster ein Strichcodemuster ist.

6. Verfahren nach einem der vorhergehenden Ansprüche, bei welchem das Codemuster in einer Zone nahe eines flachen Orientierungsrandes der Halbleiterscheibe gebildet wird.

7. Verfahren nach Anspruch 2 oder einem der Ansprüche 4 bis 6, wenn auf Anspruch 2 rückbezogen, bei welchem das Codemuster auf der vorderen Fläche der Halbleiterscheibe der Abscheidung einer Vielzahl von Schichten einschließlich einer Isolierschicht und einer Metallschicht darauf nach Schritt (a) ausgesetzt wird.

8. Verfahren nach Anspruch 3 oder einem der Ansprüche 4 bis 6, wenn auf Anspruch 3 rückbezogen, bei welchem ein aktives Element auf der vorderen Fläche der Halbleiterscheibe gebildet wird, und die Metallschicht als eine erste Metallschicht des aktiven Elementes abgeschieden wird.

9. Verfahren nach einem der vorhergehenden Ansprüche, bei welchem die optische Detektionsachse des Detektors zum Empfangen von reflektiertem Licht in Schritt (c) von der Richtung weg geneigt ist, die zum Empfangen von regelmäßig reflektiertem Licht geeignet ist, wodurch reflektiertes Licht von einem geritzten Bereich mit einer nicht-spiegelnden Reflexionseigenschaft durch den genannten Detektor empfangen wird.

10. Verfahren nach einem der Ansprüche 1 bis 8, bei welchem die optische Detektionsachse des Detektors zum Empfangen von reflektiertem Licht in Schritt (c) eingerichtet ist, mit der Richtung zusammenzufallen, die zum Empfangen von regelmäßig reflektiertem Licht geeignet ist.

## Revendications

1. Procédé d'identification d'une plaquette semi-conductrice, utilisant une combinaison de code formée sur ou au-dessus d'une face principale définissant la face avant de la plaquette et une source lumineuse et un détecteur disposés au droit de la face principale opposée définissant la face arrière de la plaquette, le procédé comprenant les étapes de :
(a) formation de la combinaison de code pour constituer des première et seconde régions ayant des propriétés de réflexion de lumière différentes ;
(b) projection sur ladite face arrière de la plaquette semi-conductrice de rayons infrarouges issus de la source lumineuse, les rayons infrarouges pénétrant à travers la plaquette semi-conductrice jusqu'à la combinaison de code et étant réfléchis sur celle-ci ;
(c) réception desdits rayons infrarouges réfléchis à partir de la combinaison de code au droit du détecteur ; et
(d) identification de la plaquette semi-conductrice en décodant le signal lumineux reçu.

2. Procédé selon la revendication 1, dans lequel la combinaison de code est formée en gravant de manière sélective la face avant de la plaquette semi-conductrice par un faisceau laser pour produire des zones rugueuses.

3. Procédé selon la revendication 1, dans lequel la combinaison de code est formée par dépôt d'une couche métallique sur ou au-dessus de la face avant de la plaquette semi-conductrice et en gravant de manière sélective la couche métallique et en rendant rugueuse une surface, de la plaquette ou d'une autre couche, sous la couche métallique par un faisceau laser.

4. Procédé selon la revendication 1, 2 ou 3 dans lequel un élément actif est formé sur la face avant de la plaquette semi-conductrice.

5. Procédé selon la revendication 1, 2, 3 ou 4 dans lequel la combinaison de code est une combinaison de code à barres.

6. Procédé selon l'une quelconque des revendications précédentes, dans lequel la combinaison de code est formée dans une région proche d'un bord plat d'orientation de la plaquette semi-conductrice.

7. Procédé selon la revendication 2, ou l'une quelconque des revendications 4 à 6 considéré comme dépendante de la revendication 2, dans lequel la combinaison de code sur la face avant de la plaquette semi-conductrice est soumis au dépôt sur celle-ci, après l'étape (a), de plusieurs couches comprenant une couche isolante et une couche métallique.

8. Procédé selon la revendication 3, ou l'une quelconque des revendications 4 à 6 considérées comme dépendantes de la revendication 3 dans lequel un élément actif est formé sur la face avant de la plaquette semi-conductrice et dans lequel la couche métallique est déposée comme première couche métallique de l'élément actif.

9. Procédé selon l'une quelconque des revendications précédentes, dans lequel l'axe optique de détection du détecteur pour recevoir la lumière réfléchie à l'étape (c), est écarté de la direction appropriée pour la réception de la lumière réfléchie de façon régulière, ce par quoi la lumière réfléchie à partir d'une zone gravée ayant une propriété de réflexion non spéculaire est reçue par ledit détecteur.

10. Procédé selon l'une quelconque des revendications 1 à 8, dans lequel l'axe optique de détection du détecteur pour recevoir la lumière à l'étape (c) est placé de manière à coïncider avec la direction appropriée pour la réflexion de la lumière réfléchie de façon régulière.
